# EUROPÄISCHE PATENTSCHRIFT

(11) **EP 0 554 681 B1**
(45) Veröffentlichungstag und Bekanntmachung des Hinweises auf die Patenterteilung: **12.06.1996**
(21) Anmeldenummer: 93100453.5
(22) Anmeldetag: 14.01.1993
(51) Int. Cl.: H01F 6/00, H01F 6/06

(54) **Trägerkörper für supraleitende Spulen**
Carrier for super-conducting coils
Porteur pour bobines supra-conduction

(30) Priorität: 07.02.1992 DE 4203524
(43) Veröffentlichungstag der Anmeldung: 11.08.1993
(73) Patentinhaber: VACUUMSCHMELZE GMBH, D-63412 Hanau (DE)
(72) Erfinder: Tenbrink, Johannes, Dr., W-8752 Mömbris (DE)
(74) Vertreter: Fuchs, Franz-Josef, Dr.-Ing.

(56) Entgegenhaltungen:
- EP-A- 0 290 331
- EP-A- 0 298 461
- EP-A- 0 406 862
- DE-A- 3 731 266
- DE-A- 4 104 421
- METALL, Jahrg. 43, Nr. 5, Mai 1989, A. SZULCZYK et al. "Herstellung von Nb3Sn- und YBa2-Cu307-Supraleitern in Drahtform" Seiten 418-423

## Beschreibung

Die Erfindung betrifft einen Trägerkörper für supraleitende Spulen mit einer Wicklung aus einem länglichen supraleitenden Verbundkörper. Neben den klassischen Supraleitern, wie beispielsweise Nb-Ti und Nb3Sn sind in jüngster Zeit supraleitende Verbundkörper bekannt geworden, bei denen ein oxidkeramisches supraleitendes Pulver von einem Hüllmaterial umschlossen ist. Solche oxidkeramischen Verbundkörper sind beispielsweise in der Veröffentlichung von H. Krauth und A. Szulczyk in METALL, Jg. 45, Heft 5, 1989, Seiten 418 ff beschrieben. Zu den besonders geeigneten oxidkeramischen Materialien gehören Phasen in den Systemen YBaCuO, BiSrCaCuO und TlBaCaCuO.

Zur Herstellung technischer Leiter werden diese oxidkeramischen Pulver beispielsweise in ein Metallrohr eingefüllt, aus dem ein Draht oder ein Band hergestellt wird. Als geeignete Materialien für das Metallrohr haben sich insbesondere Silber und Silberlegierungen (vgl. EP-OS 290 331, DE-OS 37 31 266, . DE P 41 04 421.5 entspricht EP-A-499 049, mit Veroffentlichungsdatum 19.8.92, und ist somit nur unter dem Aspekt der Neuhert zu betrachten) erwiesen, da bei diesen die erforderliche Sauerstoffpermeation gewährleistet ist. In der nicht vorveröffentlichten deutschen Patentanmeldung P 41 04 421.5 werden dispersionsgehärtete Silberlegierungen als Hüllmaterial vorgeschlagen. Es handelt sich dabei insbesondere um AgMgNi-, AgMnNi- und AgAl-Legierungen, bei denen die Legierungszusätze lediglich 0,005 bis 2 Gew.-% betragen, so daß sie einen Silbergehalt von vorzugsweise mehr als 98 Gew.-% aufweisen. Verglichen mit reinem Silber weisen diese Legierungen verbesserte mechanische Werte, wie eine erhöhte Härte und Festigkeit auf.

Ferner ist es aus der EP-OS 406 862 bereits bekannt, daß mit oxidkeramischen supraleitenden Verbunddrähten Wicklungen für Spulen hergestellt werden können. Dazu wird der oxidkeramische Verbundkörper als Wicklung auf einen Trägerkörper aufgebracht. Die Wickeleinheit muß anschließend noch einer Wärmebehandlung bei einer Temperatur von etwa 900 °C unterzogen werden, um die supraleitenden Eigenschaften der Verbunddrähte einzustellen.

Es hat sich nunmehr gezeigt, daß bei der Herstellung von Spulen mit oxidkeramischen Verbundleitern der Trägerkörper eine an den Verbundleiter angepaßte Wärmedehnung aufweisen muß, um beim Abkühlen von der Temperatur der Abschlußglühung (etwa 900 °C) auf die Anwendungstemperatur von 77 K bzw. 4,2 K die für oxidkeramische Verbunddrähte maximal zulässige Dehnung nicht zu überschreiten. Zudem sollen die Trägerkörper vorzugsweise eine hohe Festigkeit und/oder zumindest auf der Wicklungsseite einen als Isolation ausreichenden elektrischen Widerstand aufweisen. Ziel der Erfindung ist es daher, entsprechende Trägerkörper zur Verfügung zu stellen.

Diese Aufgabe wird durch Trägerkörper gelöst, die die Merkmale des Anspruchs 1 bzw. 10 aufweisen. Vorteilhafte Ausgestaltungen sind in den Unteransprüchen beschrieben. Gemäß Anspruch 1 enthält der Trägerkörper als Material eine im wesentlichen aus Silber bestehende oxiddispers gehärtete bzw. aushärtbare Legierung. Durch ihren hohen Silbergehalt weist diese Legierung eine Wärmedehnung auf, die an die Wärmedehnung der oxidkeramischen Verbunddrähte mit einer Hülle aus Silber bzw. einer Silberlegierung angepaßt ist. Es hat sich nämlich gezeigt, daß die Wärmedehnung der Verbunddrähte im wesentlichen durch das Mantelmaterial bestimmt wird und deshalb weitgehend der Wärmedehnung von Silber entspricht. Die Wärmedehnung des erfindungsgemäßen Trägerkörpers entspricht aufgrund des hohen Silbergehaltes der verwendeten Legierung ebenfalls weitgehend der Wärmedehnung von Silber. Daher ist es möglich, die beim Abkühlen von der Temperatur der Abschlußglühung auf die Anwendungstemperatur von 77 K bzw. 4,2 K auftretende Dehnung unterhalb eines kritischen Wertes zu halten, der etwa bei 0,2 % liegt. Im einzelnen können insbesondere die bereits in der deutschen Patentanmeldung P 41 04 421.5 offenbarten dispersionsgehärteten Silberlegierungen für den Trägerkörper verwendet werden. Diese Silberlegierungen weisen im gehärteten Zustand eine hohe Härte und Festigkeit auf. Insbesondere handelt es sich dabei um AgMg-, AgMgNi-, AgMnNi- und AgAl-Legierungen. Im Falle der AgMg- bzw. AgMgNi-Legierungen enthalten diese neben Silber vorzugsweise 0,1 bis 0,25 Gew.-% Mg, 0,1 bis 0,25 Gew.-% Ni, Rest Silber. Bei den AgMnNi-Legierungen werden solche mit einem Gesamtgehalt an Mn und Ni von 0,5 bis 1,5 Gew.-%, Rest Silber, bevorzugt. Die bevorzugten AgAl-Legierungen weisen neben Silber einen Al-Gehalt von 0,05 bis 0,6 Gew.-% auf. Mit den oxiddispers gehärteten bzw. aushärtbaren Legierungen können Trägerkörper hergestellt werden, die neben einer angepaßten Wärmedehnung insbesondere eine erhöhte Festigkeit aufweisen.

Spielt die Festigkeit dagegen eine untergeordnete Rolle, wie dies bei Spulenkörpern ohne besondere mechanische Belastungen - z. B. bei kleineren Feldern oder für Testwicklungen - der Fall ist, so können als Material für den Trägerkörper insbesondere auch die in den Ansprüchen 11 bis 14 beschriebenen, im wesentlichen aus Silber bestehenden Legierungen eingesetzt werden, die eine dichte Deckoxidschicht aufweisen. Entsprechende Trägerkörper weisen neben der angepaßten Wärmedehnung aufgrund des hohen Silbergehaltes einen erhöhten elektrischen Widerstand aufgrund der Deckoxidschicht auf und wirken daher isolierend. Besonders bevorzugt werden hierbei Silberlegierungen, die neben Silber 0,2 bis 5 Gew.-%, insbesondere 0,2 bis 2 Gew.-% mindestens eines der Elemente Si, Be, Al oder Mg enthalten. Ferner handelt es sich um Silberlegierungen, die neben Silber 1 bis 10 Gew.-% Sn und/oder Zn enthalten. Schließlich kommen hierfür auch AgCd-Legierungen mit einem Cd-Gehalt von 5 bis 15 Gew.-% infrage, die durch geringe Zusätze von weniger als 1 Gew.-% Al und/oder 2 Gew.-% Zn zur Bildung dichter Deckoxidschichten neigen.

Besonders bevorzugt werden Trägerkörper, die im wesentlichen aus den beschriebenen oxiddispers gehärteten bzw. härtbaren Legierungen bestehen und die zusätzlich - zumindest auf der Wicklungsseite - eine dünne Isolationsschicht aus einer zweiten im wesentlichen aus Silber bestehenden Legierung enthalten, die eine dichte Deckoxidschicht aufweist. Die Isolationsschicht kann aber auch aus Oxiden der Elemente Ni, Fe, Cr, Co, Nb, Mo, Ta, W, Re, Os, Ir, Ru, Tc oder V bestehen. Die Isolationsschicht kann beispielsweise dadurch realisiert werden, daß der Trägerkörper mit einem dünnen Band oder mit einer dünnen Schicht eines der obengenannten mit Silber nicht mischbaren Elemente oder Legierungen mit diesen Elementen versehen wird. Bei einer Glühbehandlung in sauerstoffhaltiger Atmosphäre oxidiert das Material und bildet die Isolationsschicht. Ein solcher Trägerkörper weist sowohl eine angepaßte Wärmedehnung als auch eine erhöhte Festigkeit und eine Isolation des Trägerkörpers auf.

Bei den erfindungsgemäß verwendeten oxiddispers gehärteten bzw. härtbaren Silberlegierungen erfolgt die Härtung durch innere Oxidation. Diese kann durch eine Wärmebehandlung in Luft oder sauerstoffenthaltender Atmosphäre erzielt werden. Die Aushärtung kann dabei beispielsweise bei der obengenannten Abschlußglühung miterfolgen oder auch vor dem Aufbringen der Wicklung auf den Trägerkörper durchgeführt werden. Bei den AgMgNi-Legierungen beispielsweise führt die Wärmebehandlung zur Ausscheidung von Magnesiumoxidpartikeln. Die feine Dispersion dieser harten Komponente verleiht der Legierung ihre hohe Festigkeit. Der Ni-Anteil dient aufgrund seiner begrenzten Löslichkeit in Silber zur Kornverfeinerung. Die Festigkeit von AgMgNi-Legierungen im ausgehärteten Zustand ist beispielsweise etwa doppelt so hoch wie im unausgehärteten Zustand, dessen Festigkeit mit der von reinem Silber vergleichbar ist. Auch die Härte von AgMgNi-Legierungen von typischerweise 130 HV ist bereits bei Raumtemperatur deutlich höher als die von reinem Silber (etwa 80 HV). Der Unterschied wird aber deutlich größer, wenn die Legierungen einer Wärmebehandlung bei erhöhter Temperatur unterzogen wurden. Nach Glühung bei 600 °C weist reines Silber eine Härte von nur 25 HV auf, während die Härte der beispielhaft genannten bereits durchoxidierten AgMgNi-Legierung praktisch unverändert ist.

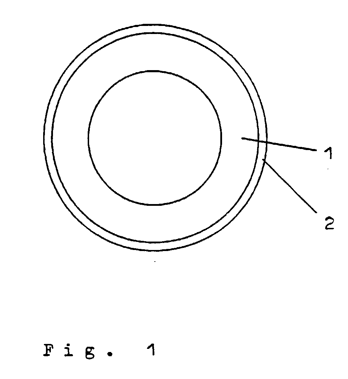

Die Figur zeigt einen Querschnitt durch einen erfindungsgemäßen Trägerkörper, der im dargestellten Beispiel hohlzylinderförmig ausgebildet ist. Der innere Teil 1 des Trägerkörpers besteht aus der oxiddispers gehärteten Legierung. Auf der Wicklungsseite ist dort eine zusätzliche Schicht 2 vorgesehen, die isolierend wirkt. Diese Schicht 2 wird aus einer im wesentlichen aus Silber bestehenden Legierung gebildet, die eine dichte (nicht eingezeichnete) Deckoxidschicht aufweist.

Als Beispiel für das Verhalten der mit einer dichten Deckoxidschicht überzogenen im wesentlichen aus Silber bestehenden Legierungen wird nachfolgend eine AgAl2-Legierung beschrieben, die 2 Gew.-% Al, Rest Silber aufweist. Hierzu wurden Untersuchungen an entsprechenden Blechen einer Dicke von etwa 1 mm durchgeführt. Die Bleche wurden Glühbehandlungen bei Temperaturen zwischen 800 und 870 °C unterworfen. Durch die Glühbehandlung bildet sich an der Oberfläche eine Schicht aus Al2O3, die bei hinreichender Schichtdicke aufgrund des hohen elektrischen Widerstands von Aluminiumoxid als Isolationsschicht wirkt. Soweit die Materialien in ihrem Inneren noch nicht oxidiertes Aluminium enthalten, ergibt sich eine Beschränkung der Prozeßtemperatur auf die Solidustemperatur von AgAl2 von etwa 880 °C.

## Patentansprüche

1. Trägerkörper für supraleitende Spulen mit einer Wicklung aus einem länglichen, supraleitenden Verbundkörper, **dadurch gekennzeichnet**, daß der Trägerkörper als Material eine im wesentlichen aus Silber bestehende oxiddispers gehärtete bzw. härtbare Legierung enthält.

2. Trägerkörper nach Anspruch 1, **dadurch gekennzeichnet**, daß es sich bei der Silberlegierung um eine Ag-Mg- bzw. Ag-Mg-Ni-Legierung handelt, die vorzugsweise (in Gew.-%) 0,1 bis 0,25 % Mg, 0,1 bis 0,25 % Ni, Rest Silber enthält.

3. Trägerkörper nach Anspruch 1, **dadurch gekennzeichnet**, daß es sich bei der Silberlegierung um eine Ag-Mn-Ni-Legierung handelt, die vorzugsweise Mn und Ni in einem Gesamtgehalt von 0,5 bis 1,5 Gew.-%, Rest Silber enthält.

4. Trägerkörper nach Anspruch 1, **dadurch gekennzeichnet**, daß es sich bei der Silberlegierung um eine Ag-Al-Legierung handelt, die vorzugsweise 0,05 bis 0,6 Gew.-% Al, Rest Silber enthält.

5. Trägerkörper nach einem der vorhergehenden Ansprüche, **dadurch gekennzeichet**, daß er auf der Wicklungsseite zusätzlich eine Isolationsschicht aufweist.

6. Trägerkörrper nach Anspruch 5, **dadurch gekennzeichnet**, daß die Isolationsschicht aus Oxiden der Elemente Ni, Fe, Cr, Co, Nb, Mo, Ta, W, Re, Os, Ir, Ru, Tc oder V besteht.

7. Trägerkörper nach Anspruch 5**, dadurch gekennzeichnet**, daß die Isolationsschicht von einer zweiten ebenfalls im wesentlichen aus Silber bestehenden Legierung gebildet wird, die eine dichte Deckoxidschicht aufweist.

8. Trägerkörper nach Anspruch 7, **dadurch gekennzeichnet**, daß die zweite Silberlegierung neben Silber 0,2 bis 5 Gew.-%, insbesondere 0,2 bis 2 Gew.-% mindestens eines der Elemente Si, Be, Al oder Mg enthält.

9. Trägerkörper nach Anspruch 7, **dadurch gekennzeichnet**, daß die zweite Silberlegierung neben Silber 1 bis 10 Gew.-% Sn und/oder Zn enthält.

10. Trägerkörper nach Anspruch 7, **dadurch gekennzeichnet**, daß die zweite Silberlegierung neben Silber (in Gew.-%) 5 bis 15 % Cd sowie 0,05 bis 1 % Al und/oder 0,05 bis 2 % Zn enthält.

11. Trägerkörper für supraleitende Spulen mit einer Wicklung aus einem länglichen, supraleitenden Verbundkörper, **dadurch gekennzeichnet**, daß der Trägerkörper von einer im wesentlichen aus Silber bestehenden Legierung gebildet wird, die eine dichte Deckoxidschicht aufweist.

12. Trägerkörper nach Anspruch 11, **dadurch gekennzeichnet**, daß die Silberlegierung neben Silber 0,2 bis 5 Gew.-%, insbesondere 0,2 bis 2 Gew.-% mindestens eines der Elemente Si, Be, Al oder Mg enthält.

13. Trägerkörper nach Anspruch 11, **dadurch gekennzeichnet**, daß die Silberlegierung neben Silber 1 bis 10 Gew.-% Sn und/oder Zn enthält.

14. Trägerkörper nach Anspruch 11, **dadurch gekennzeichnet**, daß die Silberlegierung neben Silber (in Gew.-%) 5 - 15 % Cd sowie 0,05 bis 1 % Al und/oder 0,05 bis 2 % Zn enthält.

15. Trägerkörper nach einem der vorhergehenden Ansprüche, **dadurch gekennzeichnet**, daß es sich bei dem supraleitenden Verbundkörper um einen oxidkeramischen Supraleiter handelt, der eine äußere Hülle aus Silber oder einer Silberlegierung aufweist.

## Claims

1. Carrier for superconductive coils with a winding made of an elongated superconductive composite device, characterised in that the carrier comprises as material an oxide dispersion hardened or hardenable alloy essentially consisting of silver.

2. Carrier according to claim 1, characterised in that the silver alloy is an Ag-Mg or Ag-Mg-Ni alloy which preferably contains (by weight) 0.1 to 0.25% of Mg, 0.1 to 0.25% of Ni, with the remainder silver.

3. Carrier according to claim 1, characterised in that the silver alloy is an Ag-Mn-Ni alloy which preferably contains Mn and Ni in a total content of 0.5 to 1.5% by weight, with the remainder silver.

4. Carrier according to claim 1, characterised in that the silver alloy is an Ag-Al-alloy which preferably contains 0.05 to 0.6% by weight of Al, with the remainder silver.

5. Carrier according to one of the preceding claims, characterised in that on the winding side it additionally exhibits an insulating coating.

6. Carrier according to claim 5, characterised in that the insulating coating consists of oxides of the elements Ni, Fe, Cr, Co, Nb, Mo, Ta, W, Re, Os, Ir, Ru, Tc or V.

7. Carrier according to claim 5, characterized in that the insulating coating is formed of a second alloy which also essentially consists of silver and exhibits a dense covering oxide coating.

8. Carrier according to claim 7, characterised in that apart from silver the second silver alloy contains 0.2 to 5% by weight, in particular 0.2 to 2% by weight, of at least one of the elements Si, Be, Al or Mg.

9. Carrier according to claim 7, characterised in that apart from silver the second silver alloy contains 1 to 10% by weight of Sn and/or Zn.

10. Carrier according to claim 7, characterised in that apart from silver, the second silver alloy contains (by weight) 5 to 15% of Cd and 0.05 to 1% of Al and/or 0.05 to 2% of Zn.

11. Carrier for superconductive coils with a winding made of an elongated superconductive composite device, characterized in that the carrier is formed of an alloy which essentially consists of silver and exhibits a dense covering oxide coating.

12. Carrier according to claim 11, characterised in that apart from silver the silver alloy contains 0.2 to 5% by weight, in particular 0.2 to 2% by weight of at least one of the elements Si, Be, Al or Mg.

13. Carrier according to claim 11, characterised in that apart from silver the silver alloy contains 1 to 10% by weight of Sn and/or Zn.

14. Carrier according to claim 11, characterised in that apart from silver the silver alloy contains (by weight) 5 to 15% of Cd and 0.05 to 1% of Al and/or 0.05 to 2% of Zn.

15. Carrier according to one of the preceding claims, characterised in that the superconductive composite device is a ceramic oxide superconductor which exhibits an outer sheath of silver or of a silver alloy.

## Revendications

1. Support de bobines supraconductrices avec un bobinage en corps composite supraconducteur longitudinal, caractérisé en ce que le support comprend comme matériau un alliage durcissable ou durci par dispersion d'oxyde constitué essentiellement d'argent.

2. Support selon la revendication 1, caractérisé en ce que l'alliage d'argent est un alliage Ag-Mg ou Ag-Mg-Ni, qui contient de préférence (en % en poids) 0,1 à 0,25 % Mg, 0,1 à 0,25 % Ni, le reste étant de l'argent.

3. Support selon la revendication 1, caractérisé en ce que l'alliage d'argent est un alliage Ag-Mn-Ni qui contient de préférence Mn et Ni en une teneur totale de 0,5 à 1,5 % en poids, le reste étant de l'argent.

4. Support selon la revendication 1, caractérisé en ce que l'alliage d'argent est un alliage Ag-Al, qui contient de préférence 0,05 à 0,6 % en poids d'Al, le reste étant de l'argent.

5. Support selon l'une des revendications précédentes, caractérisé en ce qu'il présente en plus une couche d'isolement du côté du bobinage.

6. Support selon la revendication 5, caractérisé en ce que la couche d'isolant est en oxydes des éléments Ni, Fe, Cr, Co, Nb, Mo, Ta, W, Re, Os, Ir, Ru, Ti ou V.

7. Support selon la revendication 5, caractérisé en ce que la couche d'isolement est constituée d'un deuxième alliage composé principalement d'argent, qui présente une couche de couverture d'oxyde étanche.

8. Support selon la revendication 7, caractérisé en ce que le deuxième alliage d'argent contient outre l'argent 0,2 à 5 % en poids, notamment 0,2 à 2 % en poids au moins d'un des éléments Si, Be, Al ou Mg.

9. Support selon la revendication 7, caractérisé en ce que le deuxième alliage d'argent contient outre l'argent 1 à 10 % en poids de Sn et/ou Zn.

10. Support selon la revendication 7, caractérisé en ce que le deuxième alliage d'argent contient outre l'argent (en % en poids) 5 à 15 % de Cd ainsi que 0,05 à 1 % de Al et/ou 0,05 à 2 % de Zn.

11. Support de bobines supraconductrices avec un bobinage en corps composite, caractérisé en ce que le support est formé d'un alliage constitué essentiellement d'argent, qui présente une couche de couverture d'oxyde étanche.

12. Support selon la revendication 11, caractérisé en ce que l'alliage d'argent contient outre l'argent 0,2 à 5 % en poids, notamment 0,2 à 2 % en poids d'au moins l'un des éléments Si, Be, Al ou Mg.

13. Support selon la revendication 11, caractérisé en ce que l'alliage d'argent contient outre l'argent 1 à 10 % en poids de Sn et/ou de Zn.

14. Support selon la revendication 11, caractérisé en ce que l'alliage d'argent contient outre l'argent (en % en poids) 5 à 15 % de Cd ainsi que 0,05 à 1 % de Al et/ou 0,05 à 2 % de Zn.

15. Support selon l'une des revendications précédentes, caractérisé en ce que le corps composite est un supraconducteur céramique oxyde, qui présente une enveloppe extérieure en argent ou en alliage d'argent.
